Europäisches Patentamt

(19) European Patent Office

Office européen des brevets

(11) Publication number: **0 057 486**
**B1**

(12) **EUROPEAN PATENT SPECIFICATION**

(45) Date of publication of patent specification: **05.02.86**

(21) Application number: **82200103.8**

(22) Date of filing: **27.01.82**

(51) Int. Cl.⁴: **H 01 L 31/02,** **F 24 J 2/04,** **F 24 J 2/46**

(54) **A collector for collecting solar radiation.**

(30) Priority: **29.01.81 NL 8100436**

(43) Date of publication of application:
**11.08.82 Bulletin 82/32**

(45) Publication of the grant of the patent:
**05.02.86 Bulletin 86/06**

(84) Designated Contracting States:
**AT BE CH DE FR GB LI NL**

(56) References cited:
**DE-A-2 622 511**
**FR-A-2 296 151**
**FR-A-2 341 827**
**FR-A-2 471 670**
**GB-A-2 024 407**
**NL-A-7 603 857**
**NL-A-7 807 865**
**US-A-4 019 494**
**US-A-4 084 579**
**US-A-4 133 159**
**US-A-4 150 657**
**US-A-4 186 720**
**US-A-4 201 190**
**US-A-4 202 320**
**US-A-4 239 555**

(73) Proprietor: **Stichting Bouwcentrum**
**Weena 700**
**NL-3014 DA Rotterdam (NL)**

(72) Inventor: **Van Heel, Joannes Marie**
**Kreitenborg 17**
**NL-4761 ST Zevenbergen (NL)**

(74) Representative: **Urbanus, Henricus Maria, Ir.**
**et al**
**c/o Vereenigde Octrooibureaux Nieuwe**
**Parklaan 107**
**NL-2587 BP 's-Gravenhage (NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a collector for collecting solar radiation, comprising a plurality of hollow, beam-shaped collector units, which may or may not be embedded in a suitable medium, and each comprising at least two sidewalls, a bottom face and at least one collecting face directed to the incident radiation and connected to the sidewalls of the hollow beam.

A similar collector is known, for example, from Dutch patent application No. 7603857. In that known collector, the hollow beams consist actually of one piece. The hollow beams are embedded in concrete in such a manner that the collecting face, formed by the top surface of each hollow beam, is flush with the surrounding concrete surface. The collecting face is heated by incident radiation. This heat can be discharged by a transporting medium passed through the hollow beams. As the heat from the collecting face is imparted, through heat conduction, to the sidewalls and the bottom face of each beam, the heat can be rapidly and efficiently transmitted to the transporting medium. Furthermore, in the prior device, heat not discharged by the transporting medium can be given up via sidewalls and bottom to the concrete, which functions as a heat storage medium.

Persons who wish to use a collector for collecting solar radiation often make different demands concerning the design of the at least one collecting face. Some users require that the collecting face is provided with a spectral-selective layer, for example, a thin layer of a material which promotes the collection of short-wave light and prevents the emission of long-wave light, to improve the efficiency of the collector. Other users prefer a plain or normal collecting face and still other users wish to have a collecting face in which for example solar cells are incorporated.

To comply with the wishes and requirements of customers in case of the known collector it is necessary to construct in advance and to store a number of different types of hollow, beam-shaped collector units, or requires to make the preferred modification in already constructed collectors. The first mentioned solution is an uneconomical one and the second mentioned solution is often an expensive and laborious matter. Thus the known collector has the disadvantage that it is not easy to comply with the requirements set by the customers.

It is an object of the present invention to provide a collector that is built up in such a manner that it comprises collector units having a collecting face that can be provided with a spectral-selective layer, or a collecting face arranged in a different manner, without the equipping of the collector units with such a different type of collecting face being expensive and laborious or without the necessity of storing a number of different collector units.

The object set is realized with a collector in which the at least one collecting face of each collector unit is a separate thin foil or thin sheet, the sidewalls of each collector unit being constructed such that said collecting face is received as a sliding cover. In such a collector any collecting unit may take the form of a container with a bottom and two longitudinally extending upright sidewalls provided at a small distance from the end remote from the bottom face with an inwardly extending flange or ridge. In the manufacture of the collector unit, the collecting face is laid on these ridges, and subsequently the part of each sidewall that projects above the collecting face is bent in the direction in which the flange or ridge extends for example by rolling. The collecting face is then virtually clamped between the ridge or flange and the bent end of the sidewall. The collecting face should then still be allowed a slight degree of movement in order that, upon heating by incident radiation, difference in coefficients of expansion between the collecting face and the sidewalls may be accommodated. The collecting face should be held in such a manner, however, as to ensure good conduction of heat from the collecting face to the sidewalls. With such a construction it is possible to use very thin foils, of thicknesses in the order of 0.1 to 0.2 mm, for the collecting face without the risk of damage.

In the apparatus according to the invention it is possible to use different types of surface depending on requirements and needs. Thus the collecting face may take the form of a foil provided with, or consisting fully of, a layer of a spectral-selective material. A nickel foil may be used for example as a surface consisting fully of spectral-selective material. An example of a composite collecting face is a thin metal band that has been provided with a spectral-selective material, for example, by evaporation of that material. Alternatively the collecting face may be formed as a thin sheet on which, or in which, an array of solar cells in strip form have been arranged. Sun rays falling on such cells generate electricity in the cells. With such a collecting face, the material around the solar cells may serve to absorb heat from the incident radiation or it may be a material which permits the passage of the radiation virtually without obstruction. In the latter case, for example, when there are used an array of silicon solar cells held between two thin glass panes, a second surface under the first may be provided to absorb the heat from the radiation passed by the first collecting face. Possibly the second collecting face may even be the bottom of the collector unit, which may be provided with a black coating for the purpose.

The collector according to the present invention may suitably be combined with a heat pump for pre-heating the medium to be evaporated in the heat pump. For that purpose the medium from the heat pump may be conducted through thin tubelets of suitable material, which are heated via the collecting face of the collector units. In an embodiment of the collector according to the invention that is suitable for that purpose, the collecting face of a collector unit consists of a thin sheet provided in the longitudinal direction of the collector unit with a clamping profile in which a thin tube can be clamped. If desired, this embodiment can be combined with the embodiment with solar cells. In that case the collector unit will be provided with a top collecting face provided with solar cells and a subjacent collecting face with a clamping profile. In that embodiment the electricity produced by the solar cells may be used for driving the heat pump.

The collector according to the invention may be formed as a collector whose collector units are embedded in a heat storage medium, in the manner described in Dutch patent application 7603857. It is also possible for the collector to be constructed in a form in which the collector units are arranged in a side-by-side array in a holder, for example, as described in Dutch patent application 7601677. Furthermore it is possible to provide the collector with separate holders into which the collector units are slid, for example, as known per se from Dutch patent application 7807865.

The invention will now be described in more detail with reference to the accompanying drawings, which show several embodiments of apparatus according to the present invention by way of example.

In said drawings,

Fig. 1 is a perspective, part-sectional view of one embodiment of a collector according to the present invention;

Figs. 2 and 3 are cross-sectional views of one embodiment of a collector unit of the collector according to the invention;

Fig. 4 is a top plan view showing a part of a different embodiment of a collector unit of the collector according to the invention; and

Figs. 5 and 6 are cross-sectional views of embodiments of the collector unit of the collector according to the invention.

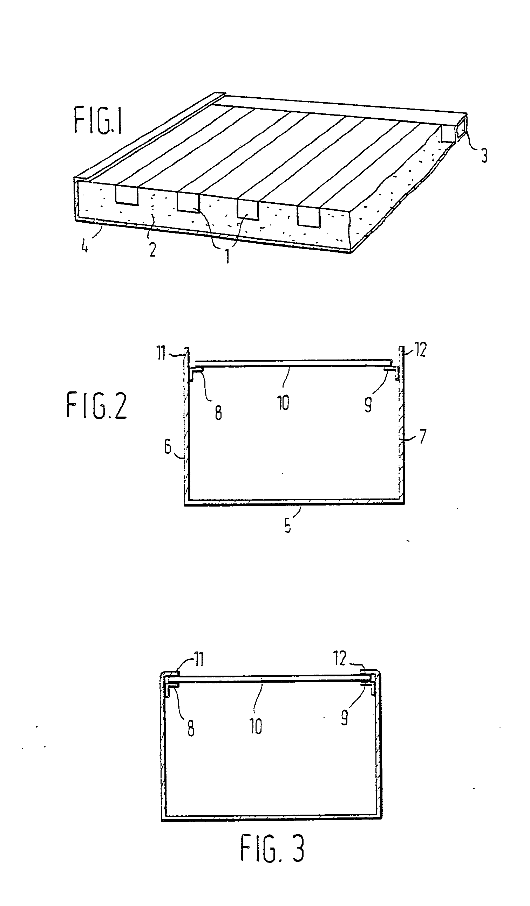

In Fig. 1 an embodiment of the collector according to the invention is shown diagrammatically in perspective view and partially in section. This embodiment corresponds to the collector according to Dutch patent application 7603857, albeit that the collector units are of an entirely different type. The collector shown comprises a plurality of collector units 1 having the form of a hollow beam. The hollow, beam-shaped collector units are embedded in concrete 2 in such a manner that the upper face of each collector unit 1, which upper face is the collecting face for solar radiation, is flush with the upper surface of the surrounding concrete 2. At the back, the collector units terminate in a hollow tube 3. Similarly, at the front, at the other ends of the collector units, a tube is provided in which the collector units terminate. The whole may be arranged in a tray 4, but this is not a requisite, as the concrete slab 2, in which all collector units and tubes are embedded, may be made to be self-supporting.

In operation, the collector units collect solar radiation, from which they become hot. Through the hollow tubes at the front and back of the collector units, a heat transporting medium, for example, air, is transported through the collector units, which medium receives, and carries along, heat from the collector units. Superfluous heat is stored in the concrete, and can be discharged from it later in a similar manner.

The invention provides a type of collector unit in which it is possible to use collecting faces as desired in a simple and economic way. For this purpose the collecting faces in each unit are separate thin foils or thin sheets, the sidewalls of each collector unit being constructed such that said collecting face is received as a sliding cover.

Figs. 2 and 3 illustrate a cross-sectional view of an embodiment of a collector unit of the collector according to the invention. The collector unit comprises a container of suitable material, for example, aluminum. This container has a bottom 5 and two upright sidewalls 6 and 7. Adjacent to the upper end of each sidewall, there is provided an inwardly projecting flange or ridge. Sidewall 6 has a flange 8 and sidewall 7 a flange 9. Flanges 8 and 9 may be provided, for example, by attaching an angle strip to the respective sidewalls 6 and 7 in a suitable manner. Naturally, it is also possible for the ridges 8 and 9 to be formed integrally with the sidewalls and the bottom 5 by the whole being formed by extrusion. Flanges 8 and 9 form a supporting surface, on which a collecting face 10 can be laid. Collecting face 10 may have any desired nature, for example, it may consist of a foil of spectral-selective material. When collecting face 10 has been placed in position, the ends of sidewalls 6 and 7, respectively designated by 11 and 12, project above the surface 10 as shown in Fig. 2. By bending ends 11 and 12 inwardly, as shown in Fig. 3, face 10, consisting of a thin sheet or foil, is clamped, like a sliding cover, between end 11 and flange 8, on one hand, and end 12 and flange 9, on the other. The bending of ends 11 and 12 should be effected in such a manner as to still allow a slight movement of face 10, for example, in order to accommodate any difference in coefficients of expansion between the material of walls 6 and 7 and of face 10 in the event of expansion. Clamping should be such, however, that, if necessary, a good heat conduction from face 10 to sidewalls 6 and 7 is possible, if collecting face 10 is a face intended for collecting heat. Instead of the ends of the sidewalls of the collector unit being bent, the collector unit could be so constructed that the ends are previously turned-up inwardly to provide a groove between flanges 8 and 9 and the turned-up ends 11 and 12. In these grooves the collecting face 10 could be slid as a sliding cover, whereafter the virtually clamping connection could be effected by rolling.

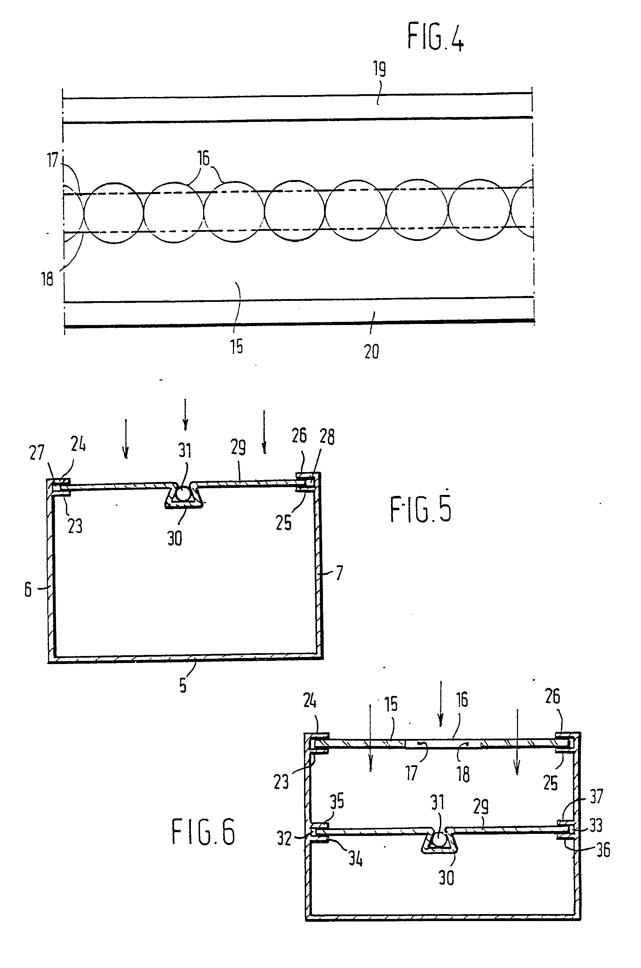

A different embodiment of a collector unit of the collector according to the invention is shown in Fig. 4 in plan view. Here again the collector unit is a container with a bottom 5 and upright sidewalls 6 and 7. The upper ends of the sidewalls are constructed in the same manner as in the embodiment of Figs. 2 and 3. Supported by inwardly extending flanges is a collecting face 15 which in the embodiment shown is a thin glass pane on which, or in which, an array of solar cells 16 have been provided. Extending through the solar cells, which are shown diagrammatically only, are two thin conductive wires 17 and 18 for carrying off electricity generated in cells 16. Collecting face 15 is held down on the flanges by the inwardly bend ends 19 and 20 of sidewalls 6 and 7 respectively.

In the embodiment illustrated in Figs. 3 and 4, the collecting face 15 for collecting radiation serves for the production of electricity. Part of the incident radiation passes around the solar cells through the glass of pane 15. For a good collection of this radiation the bottom 5 of the collector unit is provided, for example, with a black coating or with a layer of another suitable material.

Fig. 5 shows still another embodiment of a collector unit of the collector according to the invention in cross-sectional view. In this embodiment the collector unit comprises a bottom 5 and upright sidewalls 6 and 7. Sidewalls 6 and 7 are provided at their upper ends with two inwardly projecting flanges or ridges 23, 24 and 25, 26, respectively. Flanges 23 and 24 define a slot or groove 27 between them, and a slot or groove 28 is present between flanges 25 and 26. Collecting face 29 fits in slots 27 and 28. Collecting face 29 consists of a thin sheet provided in the longitudinal direction of the collector unit with a clamping profile 30. Clamping profile 30 accommodates a thin tube 31, which may form part of a heat pump system.

Fig. 6 shows an embodiment of a collector unit of the collector according to the invention in cross-sectional view, which in essence is a combination of the embodiments shown in Figs. 4 and 5. The embodiment illustrated in Fig. 6 comprises two collecting faces provided one beneath the other. The top collecting face 15 is of a construction similar to collecting face 15 of Fig. 4. It is secured in the manner of collecting face 29 of Fig. 5.

The second collecting face 29 is similar to collecting face 29 of Fig. 5. It is secured in the slots or grooves 32 and 33 provided between pairs of flanges or ridges 34, 35, and 36, 37, respectively projecting from walls 6 and 7.

## Claims

1. A collector for collecting solar radiation, comprising a plurality of hollow, beam-shaped collector units (1), which may or may not be embedded in a suitable medium (2), and each comprising at least two sidewalls (6, 7), a bottom face (5) and at least one collecting face (10, 15, 29) directed to the incident radiation and connected to the sidewalls (6, 7) of the hollow beam, characterized in that said at least one collecting face (10, 15, 29) of each collector unit (1) is a separate thin foil or thin sheet, said sidewalls (6, 7) of each collector unit (1) being constructed such that said collecting face (10, 15, 29) is received as a sliding cover.

2. A collector according to claim 1, characterized in that the collecting face (10, 15, 29) is formed as a foil provided with or consisting of a layer of a spectal-selective material.

3. A collector according to claims 1—2, characterized in that the collecting face (15) is a thin sheet on which or in which an array of solar cells are provided in strip form.

4. A collector according to claims 1—2, characterized in that the collecting face (29) is a thin sheet provided in the longitudinal direction of the collector unit with a clamping profile (30) in which a thin tube (31) can be clamped.

5. A collector according to claim 1, characterized in that one or more collector units (1) of the collector are provided with a first collecting face (15) of a material permeable to radiation, on which, or in which an array of solar cells (16) in strip form are arranged, and a second collecting face (29) subjacent thereto, as viewed in the direction of incidence of the radiation, said second collecting face (29) being a thin sheet which in the longitudinal direction of the collector unit is provided with a clamping profile (30) in which a thin tube (31) can be clamped.

## Revendications

1. Collecteur solaire, comprenant une multiplicité d'unités (1) de collecteur creuses et en forme de poutre, qui peuvent ou non être noyées dans un milieu (2) approprié, et chacune comprenant au moins deux parois latérales (6, 7), une face de fond (5) et au moins une face de collecte (10, 15, 29) tournée vers les radiations incidentes et reliée aux parois latérales (6, 7) de la poutre creuse, caractérisé en ce que ladite (ou lesdites) face de collecte (10, 15, 29) de chaque unité (1) de collecteur est une feuille mince ou une lame mince séparée, lesdites parois latérales (6, 7) de chaque unité (1) de collecteur étant réalisées de sorte que ladite face de collecte (10, 15, 29) soit reçue comme un couvercle coulissant.

2. Collecteur selon la revendication 1, caractérisé en ce que la face de collecte (10, 15, 29) est constituée d'une feuille munie, ou constituée, d'une couche en matériau à sélectivité spectrale.

3. Collecteur selon les revendications 1 ou 2, caractérisé en ce que la face de collecte (15) est une lame mince sur laquelle ou dans laquelle une rangée de cellules solaires sont prévues en forme de bande.

4. Collecteur selon les revendications 1 ou 2, caractérisé en ce que la face de collecte (29) est une lame mince munie, dans la direction longitudinale de l'unité de collecteur, d'un profilé de serrage (30) dans lequel un tube mince (31) peut être serré.

5. Collecteur selon la revendication 1, caractérisé en ce qu'une ou plusieurs unités (1) de collecteur du collecteur sont munies d'une première face de collecte (15) en un matériau perméable aux radiations, sur laquelle, ou dans laquelle, une rangée de cellules solaires (16) en forme de bande sont disposées, et d'une seconde face de collecte (29) sous-jacente à celle-ci dans la direction d'incidence des radiations, ladite seconde face de collecte (29) étant une lame mince qui, dans la direction longitudinale de l'unité de collecteur, est munie d'un profilé de serrage (30) dans lequel un tube mince (31) peut être serré.

## Patentansprüche

1. Solarkollektor zum Sammeln der Sonnenstrahlung, bestehend aus einer Vielzahl von hohlen, balkenförmigen Kollektorelementen (1), welche in einem geeigneten Trägermaterial (2) eingebettet sein können und von denen jedes aus mindestens zwei Seitenwänden (6, 7), einem Boden (5) und mindestens einer, auf die einfallende Sonnenstrahlung ausgerichtete und an den Seitenwänden (6, 7) des hohlen Balkens befestigte Kollektorfläche (10, 15, 29) besteht, dadurch gekennzeichnet, daß mindestens eine Kollektorfläche (10, 15, 29) jedes Kollektorelementes (1) eine besondere, dünne Folie oder eine besondere, dünne Platte ist, daß die Seitenwände (6, 7) jedes Kollektorelementes (1) so gestaltet sind, daß die Kollektorfläche (10, 15, 29) als gleitfähige Abdeckung gehalten wird.

2. Solarkollektor gemäß Anspruch 1, dadurch gekennzeichnet, daß die Kollektorfläche (10, 15, 29) eine Folie ist, die mit einer Schicht eines spektralselektiven Materials versehen ist oder aus einer solchen Schicht besteht.

3. Solarkollektor gemäß Anspruch 1 bis 2, dadurch gekennzeichnet, daß die Kollektorfläche (15) eine dünnen Platte ist, auf der oder in der eine Reihe von Solarzellen in Streifenform angeordnet ist.

4. Solarkollektor gemäß Anspruch 1 bis 2, dadurch gekennzeichnet, daß die Kollektorfläche (29) eine dünne Platte ist, die in der Richtung der Längsausdehnung des Kollektorelementes mit einem Klemmprofil (30) versehen ist, in das ein Röhrchen (31) einklemmbar ist.

5. Solarkollektor gemäß Anspruch 1, dadurch gekennzeichnet, daß ein oder mehrere Kollektorelemente (1) des Solarkollektors mit einer ersten Kollektorfläche (15) aus einem strahlungsdurchlässigen Material versehen sind, auf dem oder in dem eine Reihe von Solarzellen (16) in Streifenform angeordnet sind und daß eine zweite Kollektorfläche (29) betrachtet aus der Richtung des Strahlungseinfalles darunterliegt und daß die zweite Kollektorfläche (29) eine dünne Platte ist, die in Längsrichtung der Kollektoreinheit mit einem Klemmprofil (30) versehen ist, in das ein dünnes Röhrchen (31) einsetzbar ist.

FIG.1

4   2   1   3

FIG.2

11   12

8   10   9

6   7

5

11   12

8   10   9

FIG. 3

1

FIG.4

FIG.5

FIG.6